# EUROPEAN PATENT APPLICATION

(11) **EP 3 562 031 A1**
(43) Date of publication of application: **30.10.2019**
(21) Application number: 18195660.8
(22) Date of filing: 20.09.2018
(51) Int. Cl.: H02S 20/20

(54) **MOUNTING DEVICE FOR PHOTOVOLTAIC MODULE AND PHOTOVOLTAIC MODULE ASSEMBLY**

(30) Priority: 23.04.2018 CN 201810366479; 20.08.2018 WO PCT/CN2018/101348
(71) Applicant: Beijing Apollo Ding Rong Solar Technology Co., Ltd., Beijing 100176 (CN)
(72) Inventor: LV, Hejiang, Beijing, 100176 (CN)
(74) Representative: Inchingalo, Simona

(57) **Abstract**

The present disclosure relates to a mounting device for a photovoltaic module. The mounting device includes a regulating mechanism and two supporting beams to install the photovoltaic module. The regulating mechanism is respectively connected to the two supporting beams to regulate an interval and/or an angle between the two supporting beams. The interval and/or the angle between the two supporting beams can be regulated according to the installation condition to adapt to photovoltaic modules with different shapes and different sizes or adapt to different installation environments. The mounting device can be produced and assembled in the factory and transported to the installation site to install the photovoltaic module. The installation process of the photovoltaic module by using the mounting device is simple and quick, during which only easy regulation is needed and the professional calibration is avoided. In addition, the mounting device has a strong universality and practicability.

## Description

### CROSS-REFERENCE TO RELATED APPLICATIONS

This application claims the benefit of priorities to China Patent Application No. 201810366479.9 titled "Mounting Device for Photovoltaic Module and Photovoltaic Module Assembly" and filed on April 23, 2018 and International Patent Application No. PCT/CN2018/101348 titled "Mounting Device for Photovoltaic Module and Photovoltaic Module Assembly" and filed on August 20, 2018, the contents of which are hereby incorporated by reference.

### TECHNICAL FIELD

The present disclosure relates to the technical field of photovoltaic application, and more particularly, to mounting devices for photovoltaic modules and photovoltaic module assemblies.

### BACKGROUND

In a conventional mounting device for photovoltaic module, a frame is mainly made by steel material and aluminum material, and a supporting structure to install the photovoltaic module is usually assembled by various connecting pieces and screws. According to environment conditions that the photovoltaic modules to be installed, components of different supporting structures for the photovoltaic modules are designed by the designer, produced in the factory, transported to a site, and assembled on the site. The photovoltaic modules are installed on the supporting structures that assembled on the site after the supporting structures are calibrated by professionals.

For example, when to install the photovoltaic modules on a colored steel sheet roof, the components of the supporting structures designed according to the installation environment are separately transported to the installation site and the supporting structures are assembled onsite to install the photovoltaic modules. So it takes a long time to install the photovoltaic modules and the installation operation is complicated. In addition, the assembled supporting structures need to be calibrated to meet the installation requirements of the photovoltaic modules, which require the installation workers have high skills. Furthermore, since the installation is finished on the colored steel sheet roof and the number and the weight of the components of the supporting structures are high, it is difficult to control the total weight of the installation to meet the load-bearing requirements of the colored steel sheet roof.

### SUMMARY

In view of this, to address the problem that the installation of the photovoltaic module by using the conventional mounting device takes a long time and has high technology requirements to workers, it is necessary to provide a mounting device with a strong universality by which the installation efficiency and the installation convenience of the photovoltaic module can be greatly improved. In addition, a photovoltaic module assembly comprising the mounting device is also provided.

In one embodiment, the present disclosure provides a mounting device for a photovoltaic module, the mounting device includes a regulating mechanism and two supporting beams to install the photovoltaic module, wherein the regulating mechanism is respectively connected to the two supporting beams to regulate an interval and/or an angle between the two supporting beams.

In another embodiment, the present disclosure provides a photovoltaic module assembly, the photovoltaic module assembly includes a photovoltaic module and a mounting device for the photovoltaic module, wherein the mounting device includes a regulating mechanism and two supporting beams to install the photovoltaic module, wherein the regulating mechanism is respectively connected to the two supporting beams to regulate an interval and/or an angle between the two supporting beams.

In another embodiment, the present disclosure provides a photovoltaic module assembly, the photovoltaic module assembly includes a plurality of photovoltaic modules and a plurality of mounting devices arranged in array, wherein
the plurality of mounting devices includes:
a plurality of regulating mechanisms and a plurality of supporting beams to install the photovoltaic module;
each two adjacent supporting beams are connected by at least one regulating mechanism, the at least one regulating mechanism is configured to regulate an interval and/or an angle between the two adjacent supporting beams;
each of the plurality of photovoltaic module is installed between each two adjacent supporting beams.

The mounting device for the photovoltaic module of the present disclosure comprises two supporting beams to install the photovoltaic module and a regulating mechanism to regulate an interval and/or an angle between the two supporting beams, so that the interval and/or the angle between the two supporting beams can be regulated according to the installation condition to adapt to photovoltaic modules with different shapes and different sizes or adapt to different installation environments. The mounting device can be produced and assembled in the factory according to common designs, and transported to the installation site to install the photovoltaic module. The installation process of the photovoltaic module by using the mounting device is simple and quick, during which only easy regulation is needed and the professional calibration is avoided. In addition, the mounting device has a simple structure and can be regulated according to the installation condition, thereby having a strong universality and practicability. When the mounting device is made by a light material, the mounting device can be suitable to install the photovoltaic module not only on conventional roofs, but on light steel tiling roofs with a high load-bearing requirement.

### BRIEF DESCRIPTION OF THE DRAWINGS

To describe the technical solutions of the embodiments of the present disclosure or the technical solutions in the prior art more clearly, the accompanying drawings required for describing the embodiments or the prior art will be briefly described. Apparently, the accompanying drawings in the following description show only some embodiments of the present disclosure, and a person of ordinary skill in the art may still derive other drawings from these accompanying drawings without creative efforts.
FIG. 1 is a structural schematic view of one embodiment of a mounting device for a photovoltaic module.
FIG. 2 is a structural schematic view of another embodiment of a mounting device for a photovoltaic module.
FIG. 3 is a structural schematic view of another embodiment of a mounting device for a photovoltaic module.
FIG. 4 is a structural schematic view of another embodiment of a mounting device for a photovoltaic module.
FIG. 5 is a cross section view of the mounting device taken along line A-A of FIG. 1.
FIG. 6 is an application schematic view of one embodiment of a mounting device for a photovoltaic module.
FIG. 7 is a cross section view of the mounting device taken along line B-B of FIG. 6.
FIG. 8 is a structural schematic view of one embodiment of a photovoltaic module assembl y.

### DETAILED DESCRIPTION

To describe the technical solutions of the embodiments of the present disclosure more clearly, specific embodiments of the present disclosure will now be described in detail with reference to the accompanying drawings. Apparently, the described embodiments are merely part and not all of embodiments of the present disclosure. Other embodiments obtained based on the embodiments of the present disclosure without creative work by those ordinary skilled in the art shall fall within the protection scope of the present disclosure.

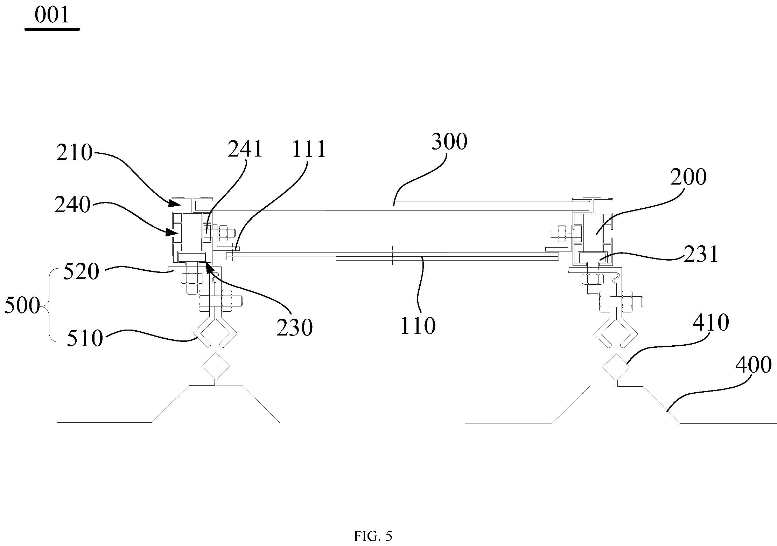

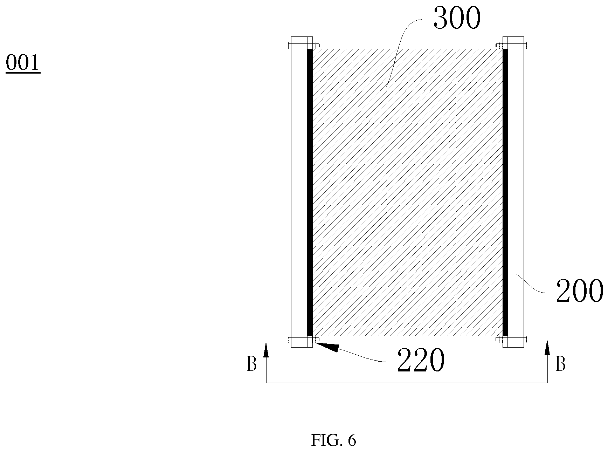

A mounting device 001 for a photovoltaic module 300 of the present disclosure can be regulated according to the photovoltaic module 300 to be installed or a mounting surface 400, thereby having strong versatility and practicality. The mounting surface 400 can be a surface which the photovoltaic module 300 is to be installed on, such as a surface of a roof, a wall, or a tile structure. The structural schematic views of the photovoltaic module 300 and the mounting surface 400 can be referred to FIG. 5 and FIG. 6. The mounting device 001 can be assembled in the production process, so that an onsite assembly of the mounting device 001 can be avoided, thereby greatly increasing the installation efficiency of the photovoltaic module 300 and reduced the technical requirements to the installation.

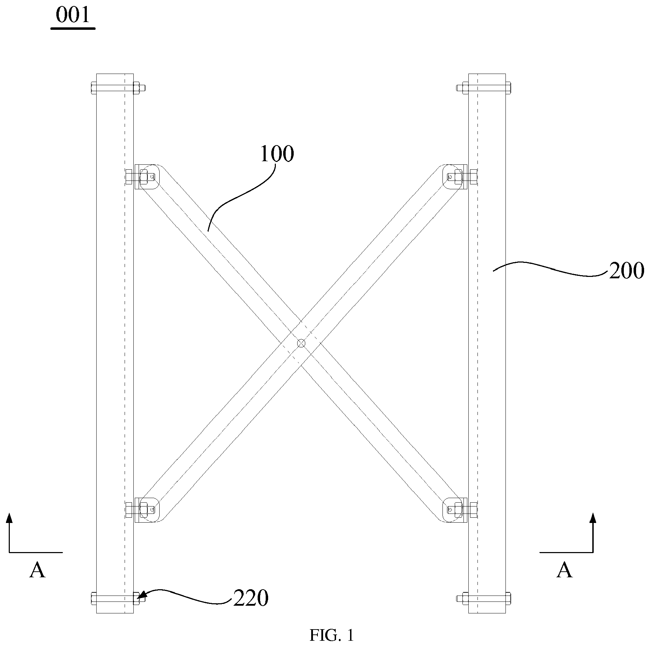

Referring to FIG. 1, the mounting device 001 can include a regulating mechanism 100 and two supporting beams 200. Structures of the two supporting beams 200 can be identical. The two supporting beams 200 can be disposed at different positions of the mounting device 001. The two supporting beams 200 are configured to install the photovoltaic module 300. The regulating mechanism 100 is connected to the two supporting beams 200 respectively, and configured to regulate an interval and/or an angle between the two supporting beams 200.

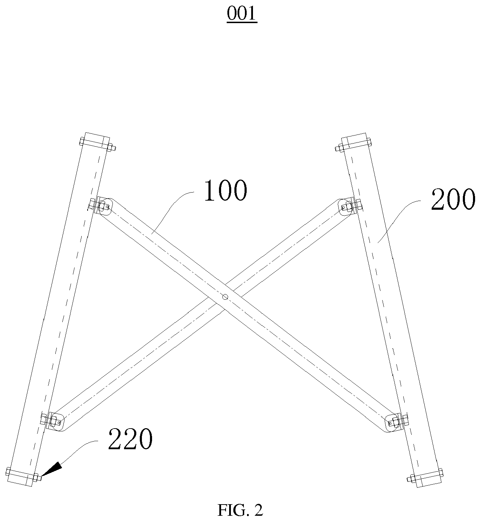

It should be noted that the two supporting beams 200 are configured to install the photovoltaic module 300, and meanwhile, to be fixedly installed on the mounting surface 400. That is, the photovoltaic module 300 can be fixedly installed on the mounting surface 400 through the two supporting beams 200. In one embodiment, the two supporting beams 200 can be spaced from each other and parallel to each other under the regulation action of the regulating mechanism 100. The two supporting beams 200 can be configured to install the photovoltaic modules 300 substantially shaped as rectangles with different sizes (referring to FIG. 1 and FIG. 6). In another embodiment, the two supporting beams 200 can be angularly spaced from each other under the regulation action of the regulating mechanism 100. The two supporting beams 200 can be configured to install the photovoltaic modules 300 substantially shaped as trapezoid or triangle with different sizes (referring to FIG. 2).

The mounting device 001 of the present disclosure are described in detail with reference to FIG.5, FIG. 6, and FIG. 7 in which the two supporting beams 200 are spaced from each other and parallel to each other as shown in FIG. 1.

The photovoltaic module 300 can be installed on the two supporting beams 200 by various ways. Referring to FIG. 5, in one embodiment, the two supporting beams 200 can be respectively provided with a sliding slot 210 extending along a length direction of the corresponding supporting beam 200. Two openings of the two sliding slots 210 of the two supporting beams 200 are opposite to each other to install the photovoltaic module 300. In the present embodiment, the photovoltaic module 300 can be installed on the two supporting beams 200 by sliding into the two sliding slots 210. The installation method of the photovoltaic module 300 is simple with a reliable contact, and the photovoltaic module 300 can be installed and detached conveniently, which facilitates the maintenance of the photovoltaic module 300. In another embodiment, the photovoltaic module 300 can be bonded onto the two supporting beams 200 to realize the installation of the photovoltaic module 300.

When the photovoltaic module 300 is installed on the two supporting beams 200 through the two sliding slots 210, an edge of the photovoltaic module 300, which is used to cooperate with the sliding slot 210 to finish the installation, can be previously sleeved with an installation protective edge to protect the photovoltaic module 300, so shat the installation of the photovoltaic module 300 is more reliable.

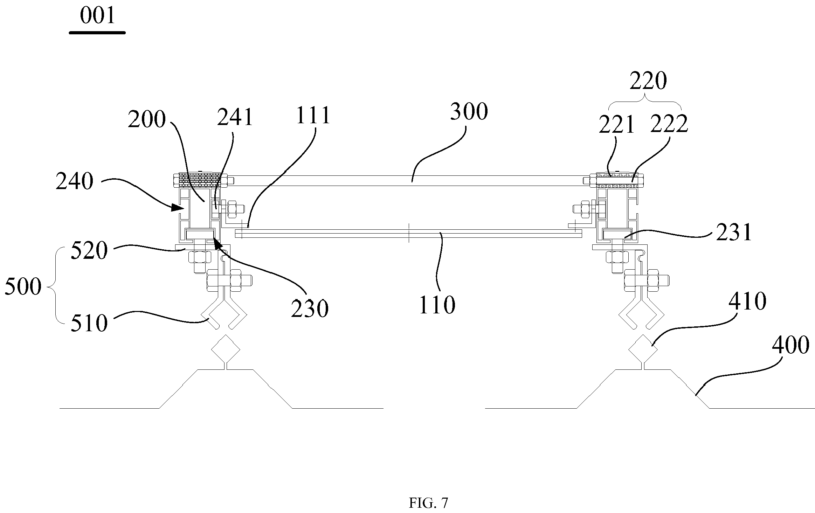

Referring to FIG. 6 and FIG. 7, each sliding slot 210 can be extended through two end surfaces of the corresponding supporting beam 200. In the present embodiment, by extending the sliding slot 210 through the two end surfaces of the corresponding supporting beam 200, the photovoltaic module 300 can be slid into the sliding slot 210 from any one of the two ends of the supporting beam 200 to be fixed, so that the installation is more flexible and convenient.

The two ends of each supporting beam 200 can be respectively provided with a limiting structure 220 configured to limit the position of the photovoltaic module 300 in the sliding slot 210. In this way, after being installed on the two supporting beams 200, the photovoltaic module 300 cannot slide out the sliding slots 210 from any one of the two ends of the supporting beam 200. The limiting structure 220 can have various configurations. In one embodiment, referring to FIG. 7, the limiting structure 220 includes a limiting head 221 and a fixing bolt 222. The limiting head 221 can be inserted into the sliding slot 210. The fixing blot 222 can be passed through a slot bottom of the sliding slot 210 and the limiting head 221 to fix the limiting head 221 to the slot bottom of the sliding slot 210. The limiting head 221 can be made by a rubber material. By inserting the limiting head 221 into the sliding slot 210 at each end of each supporting beam 200, and fixing the limiting head 221 to the sliding slot 210, the position of the photovoltaic module 300 in the sliding slot 210 can be limited, so as to prevent the photovoltaic module 300 from sliding out the sliding slot 210, thereby increasing the stability of the installation. In another embodiment, the limiting structure 220 can be a baffle, and a groove can be defined on the inner wall of the sliding slot 210 to fix the baffle therein. The baffle can be disposed at each end of each supporting beam 200 to limit the position of the photovoltaic module 300 in the sliding slots 210.

The supporting beam 200 can be fixed installed on the mounting surface 400 by various ways. Referring to FIG. 1 and FIG. 5, in one embodiment, a mounting structure 500 can be disposed on each supporting beam 200. The mounting structure 500 can be moveably connected to the supporting beam 200. The mounting structure 500 is configured to be connected to the mounting surface 400.

That the mounting structure 500 can be moveably connected to the supporting beam 200 refers to that the mounting structure 500 can be slidably connected to the supporting beam 200 along the length direction of the supporting beam 200, or the mounting structure 500 can be rotatably connected to the supporting beam 200, or the mounting structure 500 can be slidably and rotatably connected to the supporting beam 200. Moreover, the moveably connection also refers to that when the mounting structure 500 is slidably and/or rotatably connected to the supporting beam 200 and arrives at the mounting position by sliding and/or rotating, the mounting structure 500 can be fixed to the supporting beam 200. In this way, after the interval between the two supporting beams 200 is determined and the supporting beams 200 are located according to the size of the photovoltaic module 300, a position of the mounting structure 500 on the supporting beam 200 can be further regulated so as to adapt to the fixed installation on the mounting surface 400.

The mounting structure 500 can have various configurations. In one embodiment, the mounting structure 500 can include a mounting fixture 510. A chuck 410 can be disposed on the mounting surface 400 to cooperate with the mounting fixture 510. The supporting beam 200 can be fixedly installed on the mounting surface 400 by clamping the chuck 410 with the mounting fixture 510. By clamping the chuck 410 with the mounting fixture 510 to fixedly install the supporting beam 200 on the mounting surface 400, types of the chuck 410 can be changed according to the structure of the mounting surface 400, and types of the mounting fixture 510 can also be changed correspondingly, so that the installation of the photovoltaic module 300 with the mounting device 001 is more flexible and applicable.

In one embodiment, with respect to the configuration that the mounting structure 500 is slidably disposed on the supporting beam 200, each supporting beam 200 can be provided with a mounting groove 230 extending along the length direction of each supporting beam 200. A second sliding block 231 can be slidably disposed in the mounting groove 230. The mounting structure 500 can have a connecting portion 520 correspondingly. The mounting structure 500 can be slidably connected to the supporting beam 200 by connecting the connecting portion 520 to the second sliding block 231.

In one embodiment, the mounting structure 500 can include the mounting fixture 510 and the connecting portion 520. The mounting fixture 510 can be connected to the connecting portion 520. The mounting fixture 510 can have a clamping portion fit to the chuck 410. The mounting structure 500 can be slidably disposed in the mounting groove 230. The second sliding block 231 can be slidably disposed in the mounting groove 230. In one embodiment, the second sliding block 231 can be a T-shaped bolt which can be connected to the connecting portion 520 by using a nut. More specifically, a screw hole can be defined on the connecting portion 520 through which the T-shaped bolt can be passed. The T-shaped bolt can be slidably disposed in the mounting groove 230. The mounting fixture 510 can be slid on the supporting beam 200 to adjust the position of the mounting fixture 510 according to the current installation condition. In addition, before the connecting portion 520 is fixedly connected to the T-shaped bolt by tightening the nut, the mounting fixture 510 having the connecting portion 520 can be freely rotated, so that the installation of the supporting beam 200 and the mounting surface 400 can be adjusted more flexible, which is beneficial for the installation of the supporting beam 200 with different mounting surfaces 400. In the present embodiment, the mounting device 001 has simple structure, convenient operation, and high use reliability. In addition, the installation can be realized by using the commonly used bolt and nut without any specially designed accessory.

In another embodiment, a mounting rail can be disposed on the supporting beam 200 along the length direction of the supporting beam 200. A sliding sleeve fit to the mounting rail can be disposed on the mounting structure 500. The sliding sleeve can be sleeved on the mounting rail and slid along the mounting rail, so that the mounting structure 500 can be slidably connected to the supporting beam 200.

Furthermore, in one embodiment, the interval and/or angle between the two supporting beam 200 can be regulated by the regulating mechanism 100 before the photovoltaic module 300 is installed on the mounting device 001 or before the mounting device 001 is installed on the mounting surface 400 to adapt to the installation of the photovoltaic module 300.

The regulating mechanism 100 can have various configurations. Referring to FIG. 1 and FIG. 5, in on embodiment, the regulating mechanism 100 can include a first regulating rod 110. Two ends of the first regulating rod 110 are respectively movably connected to the two supporting beams 200. An angle of the first regulating rod 110 with respect to each supporting beams 200 can be regulated.

The movably connection can refer to that each end of the first regulating rod 110 can be slid along the length direction of the corresponding supporting beam 200 and rotated with respect to the corresponding supporting beam 200. Moreover, the movably connection can also refer to that when the two ends of the first regulating rod 110 respectively arrives at a preset position by sliding along the corresponding supporting beam 200 and rotating with respect to the corresponding supporting beam 200, the two ends of the first regulating rod 110 can be fixed to the two supporting beams 200. More specifically, when the two ends of the first regulating rod 110 respectively arrives at the corresponding preset position, that is, when an angle of the first regulating rod 110 with respect to each supporting beam 200 reaches a preset value, the position of the first regulating rod 110 with respect to the two supporting beams 200 can be fixed by a fastening structure. In the present embodiment, the preset position of each end can be set according to the photovoltaic module 300 and the mounting surface 400.

In the present embodiment, by regulating the relative positions of the two ends of the first regulating rod 110 and the two supporting beam 200, the angle of the first regulating rod 110 inclined to each supporting beam 200 can be regulated, so that the interval and/or the angle between the two supporting beams 200 can be regulated.

A number of the first regulating rod 110 can be one. More specifically, two ends of the one first regulating rod 100 can be respectively slidably disposed on the two supporting beams 200. When the angle of the one first regulating rod 110 with respect to each supporting beam 200 reaches the preset value, the two ends of the one first regulating rod 100 can be respectively fixed on the two supporting beams 200. In one embodiment, when each end of the one first regulating rod 100 is moved to form an angle of 45°with the corresponding supporting beam 200, the position of the one first regulating rod 110 can be fixed with respect to the two supporting beams 200 by fastening structures. Two ends of the one first regulating rod 110 can be respectively slidably disposed on the two supporting beams 200, and the two ends of the one first regulating rod 110 can be respectively moved to different positions of the two supporting beams 200 with different heights, so that the one first regulating rod 110 can form different angles respectively with the two supporting beams. The bigger the angles of the one first regulating rod 110 inclined to the two supporting beams 200, the larger the interval between the two supporting beams 200 is. When the one first regulating rod 100 is perpendicular to the two supporting beams, the interval between the two supporting beams is maximal. It should be understood that the number of the first regulating rod 110 can be two. The two first regulating rods 110 can be parallel to, symmetric to, or intersected with each other. The regulating mechanism 100 can further include three or more first regulating rods 110.

In one embodiment, the regulating mechanism 100 can include two first regulating rods 110 intersected with each other and rotatably connected to each other. Two ends of each of the two first regulating rods 110 can be respectively slidably disposed on the two supporting beams. When the angle of each of the two first regulating rod 110 with respect to each of the two supporting beams 200 reaches a preset value, the two ends of each of the two first regulating rods 110 can be respectively fixed on the two supporting beams 200. In the present embodiment, by using two first regulating rods 110 to form two stable triangular geometric construction between the two supporting beams, the structure of the mounting device 001 is more stable.

Each supporting beam 200 can be provided with a sliding rail 240 extending along the length direction of each supporting beam 200. A first sliding block 241 can be slidably disposed in each sliding rail 240. The two ends of the first regulating rod 110 can be respectively rotatably connected to one sliding block 241. When the angle of the first regulating rod 110 with respect to each supporting beam 200 reaches the preset value, the two ends of the first regulating rod 110 can be respectively fixed to the corresponding sliding block 241.

The first sliding block 241 can be a T-shaped bolt. The first regulating rod 110 can be rotatably connected to the T-shaped bolt. More specifically, the first regulating rod 110 can be rotatably connected to the T-shaped bolt through a L-shaped connecting plate 111. A screw hole through which the T-shaped bolt can be passed is defined at a first end of the L-shaped connecting plate 111. And a second end of the L-shaped connecting plate 111 is rotatably connected to the first regulating rod 110. For example, a first connecting hole can be defined on the second end of the L-shaped connecting plate 111 configured to connect to the first regulating rod 110, and a second connecting hole can be defined on the first regulating rod 110, a bolt can be passed through the two connecting holes in sequence to rotatably connect the L-shaped connecting plate 111 with the first regulating rod 110.

In the present embodiment, due to the T-shaped bolt slidably disposed in the sliding rail 240, each end of the two regulating rods 110 can be slid on the corresponding supporting beam 200, and rotated with respect to the corresponding supporting beam 200 through the L-shaped connecting plate 111, so that the interval and/or angle between the two supporting beams 200 can be regulated. When each end of the two regulating rods 110 is moved to a preset position, that is, when the angel of each of the two regulating rods 110 with respect to each of the two supporting beams 200 reaches the corresponding preset value, the L-shaped connecting plates 111 and the T-shaped bolts can be fixed to the two supporting beams 200 by tightening the nuts, and the two regulating rods 110 can be fixed to the two supporting beams 200 by fixing the L-shaped connecting plates 111 to the first regulating rods 110. In the present embodiment, the configuration has simple structure, convenient operation, and high use reliability, in addition, the configuration can be realized by using the commonly used bolt and nut without any specially designed accessory.

Furthermore, a locating scale can be engraved on the supporting beam 200 to locate the end of the first regulating rod 110 conveniently, which is beneficial to accurately determine the interval between the two supporting beams 200.

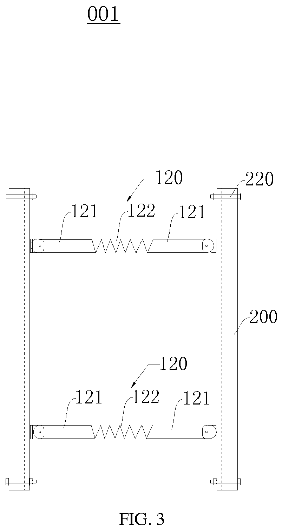

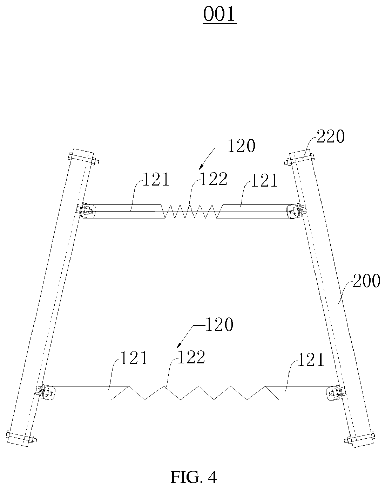

In one embodiment, referring to FIG. 3 and FIG. 4, the regulating mechanism 100 can include a second regulating rod 120. One or more second regulating rods 120 can be disposed. In one embodiment, two second regulating rods 120 substantially parallel to each other can be disposed. For example, the two second regulating rods 120 can be parallel to each other, and each end of each second regulating rod 120 can be perpendicular to the two supporting beams 200. The two ends of the second regulating rod 120 can be respectively movably connected to the two supporting beams 200. A length of the second regulating rod 120 is capable of being regulated. With the change of the lengths of the two second regulating rods 120, the interval between the two supporting beams 200 can also be changed. In the present embodiment, because the interval between the two supporting beams 200 is regulated by regulating the length of the second regulating rod 120, and the second regulating rod 120 is movably connected to the two supporting beams 200 respectively, the angle between the two supporting beams 200 can be also conveniently adjusted.

In one embodiment, referring to FIG. 3 and FIG. 4, the second regulating rod 120 can include a fixing sleeve 121 and a movable rod 122. A first end of the fixing sleeve 121 can be rotatably connected to one supporting beam 200. A second end of the fixing sleeve 121 can be sleeved on a first end of the movable rod 122. A second end of the movable rod 122 can be rotatably connected to the other one supporting beam 200. When a preset length of the movable rod 122 is extended from the fixing sleeve 121, the movable rod 122 can be fixed to the fixing sleeve 121, by which the interval between the two supporting beams 200 can be regulated conveniently. When the angle between the two supporting beams 200 reaches a preset value, the fixing sleeve 121 and the movable rod 122 can be fixed to the supporting beam 200, by which the angle between the two supporting beams 200 can be regulated according to needs. Furthermore, a locating scale can be engraved on the movable rod 122 to observe the length that the movable rod 120 is extended from the fixing sleeve 121, which is beneficial to accurately determine the interval between the two supporting beams 200.

In the present disclosure, the supporting beam 200 and the regulating rods of the regulating mechanism 100 can all be made by an aluminum alloy material. The specific positions of the sliding slot 210, sliding rail 240, and mounting groove 230 on the supporting beam 200 can be referred to FIG. 5. The sliding rail 240 can be provided on an upper surface of the supporting beam 200. Two openings of the two sliding slots 210 of the two supporting beams 200 can be opposite to each other. The sliding rail 240 can be provided on a middle portion of a side surface of the supporting beam 200. The two sliding rails 240 on the two supporting beams 200 can be opposite to each other. The mounting grove 230 can be provided on the lower surface of the supporting beam 200. The mounting grove 230 can have a downward opening.

The mounting device 001 in the present disclosure can be regulated in real time according to the photovoltaic module 300 to be installed and the mounting surface 400 to adapt to the installation without onsite assembly and calibration, thereby greatly increasing the installation efficiency and convenience. The mounting device 001 has simple structure, can be made by light aluminum material, uses few connecting members, has a light total weight, and is suitable to be installed on the roof using light steel tiling roof which has high requirement to the load-bearing.

The present disclosure further provides a photovoltaic module assembly 002 including the photovoltaic module 300 and the mounting device 001. The photovoltaic module 300 is installed between the two supporting beams 200. In the present embodiment, the photovoltaic module 300 and the mounting device 001 can be assembled directly in the production process in the factory, so that the onsite installation and regulation can be avoided. The installation personnel only need to install the photovoltaic module assembly 002 on the site, thereby further simplifying the installation work and increasing the installation efficiency.

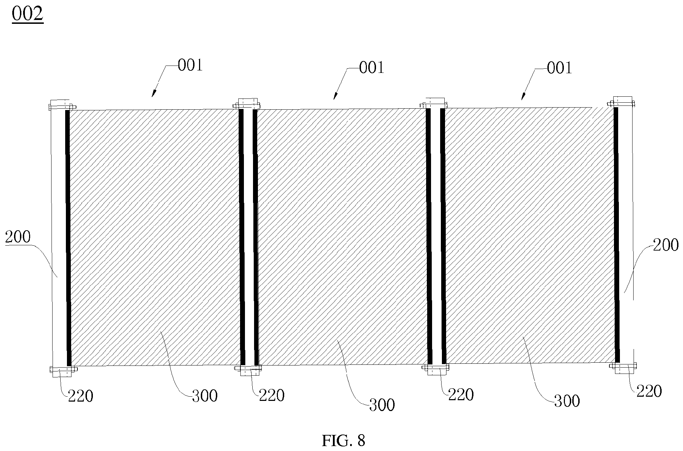

Referring to FIG. 8 showing the schematic view of one embodiment of the photovoltaic module assembly 002, in one embodiment, the photovoltaic module assembly 002 can include a plurality of photovoltaic modules 300 and a plurality of mounting devices 001 arranged in array. Each photovoltaic module 300 can be installed between two adjacent supporting beams 200.

In one embodiment, the photovoltaic module assembly 002 can include a plurality of photovoltaic modules 300 and a plurality of mounting devices 001 configured to install the plurality of photovoltaic modules 300. The number and the sizes of the mounting devices 001 arranged in every row and every column can be the same, so that the plurality of photovoltaic modules 300 with same sizes can be arranged in array. Every two adjacent supporting beams 200 in one column can be provided with a regulating mechanism 100 configured to regulate the interval or the angle between the two adjacent supporting beams 200. Except for the two supporting beams 200 disposed at the outside of the photovoltaic module assembly 002, each supporting beam 200 in the middle can be designed to be symmetrical. Referring to FIG. 5, two sliding rail 240 can be respectively provided on two side surfaces of each supporting beam 200 in the middle. The mounting grooves 230 under each supporting beam 200 in the middle can be integrated into one mounting groove 230. The photovoltaic module assembly 002 of the present disclosure has a more compact and simple overall structure, a strong applicability, and a high installation efficiency.

In one embodiment, a plurality of photovoltaic modules 300 with different sizes can be installed on the plurality of mounting devices 001 arranged in array. More specifically, the number and the sizes of the mounting devices 001 arranged in interlaced lines or columns can be the same. The specific configuration of the plurality of mounting devices 001 can be disposed according to specific technology requirements.

It should be noted that the relational terms here such as first and second are used to differentiate an entity or operation from another entity or operation, and do not require or imply any actual relationship or sequence between these entities or operations. Moreover, the terms "include," "comprise," and any variation thereof are intended to cover a non-exclusive inclusion. Therefore, a process, method, object, or device, which includes a series of elements, not only includes such elements, but also includes other elements not specified expressly, or may further include inherent elements of the process, method, object, or device. If no more limitations are made, an element limited by "include a/an ... " does not exclude other same elements existing in the process, the method, the article, or the device which includes the element.

Each embodiment in the present disclosure is described in a progressive manner. Every embodiment illustrates in emphasis what is different from the other embodiments. The same or similar parts in the embodiments are just references to each other.

The preceding description disclosed in the embodiments allows a person skilled in the art to implement or use the present disclosure. Multiple modifications to these embodiments are apparent for a person skilled in the art. The general principle defined in this specification may be implemented in other embodiments without departing from scope of the present disclosure. Therefore, the present disclosure will not be limited to the embodiments described in this specification but extends to a widest scope that complies with the principle and novelty disclosed in this specification.

## Claims

1. A mounting device for a photovoltaic module, comprising a regulating mechanism and two supporting beams to install the photovoltaic module, wherein
the regulating mechanism is respectively connected to the two supporting beams to regulate an interval and/or an angle between the two supporting beams.

2. The mounting device of the claim 1, wherein the regulating mechanism comprises at least one first regulating rod, two ends of each of the at least one first regulating rod are respectively movably connected to the two supporting beams, and an angle of each of the at least one first regulating rod with respect to each of the two supporting beams is capable of being regulated.

3. The mounting device of the claim 2, wherein the regulating mechanism comprises two first regulating rods intersected with each other and rotatably connected to each other;
two ends of each of the two first regulating rods are respectively slidably disposed on the two supporting beams; and
when an angle of each of the two first regulating rods with respect to each of the two supporting beams reaches a preset value, the two ends of each of the two first regulating rods are capable of being respectively fixed to the two supporting beams.

4. The mounting device of the claim 2, wherein the regulating mechanism comprises one first regulating rod, two ends of the one first regulating rod are respectively slidably disposed on the two supporting beams; and
when an angle of the one first regulating rod with respect to each of the two supporting beams reaches a preset value, the two ends of the one first regulating rod are capable of being respectively fixed on the two supporting beams.

5. The mounting device of any one of the claims 2 to 4, wherein the two supporting beams are respectively provided with a sliding rail extending along a length direction of the corresponding supporting beam, a first sliding block is disposed in the sliding rail;
the two ends of each of the at least one first regulating rod are respectively rotatably connected to one sliding block, and when the angle of each of the at least one first regulating rod with respect to each of the two supporting beams reaches a preset value, the two ends of each of the at least one first regulating rod are capable of being respectively fixed to the corresponding first sliding block.

6. The mounting device of any one of the claims 1 to 5, wherein the regulating mechanism comprises a second regulating rod, two ends of the second regulating rod are respectively movably connected to the two supporting beams, and a length of the second regulating rod is capable of being regulated.

7. The mounting device of the claim 6, wherein the second regulating rod comprises a fixing sleeve and a movable rod, a first end of the fixing sleeve is rotatably connected to one of the two supporting beams, a second end of the fixing sleeve is sleeved on a first end of the movable rod, a second end of the movable rod is rotatably connected to the other one of the two supporting beams;
when the angle between the two supporting beams reaches a preset value, the fixing sleeve and the movable rod are fixed to the two supporting beams; and
when a preset length of the movable rod is extended from the fixing sleeve, the movable rod is capable of being fixed to the fixing sleeve.

8. The mounting device of any one of the claims 1 to 7, wherein the two supporting beams are respectively provided with a sliding groove extending along a length direction of the corresponding supporting beam, two openings of the two sliding grooves are opposite to each other to install the photovoltaic module.

9. The mounting device of the claim 8, wherein the sliding groove is extended through two end surfaces of the corresponding supporting beam, two ends of each supporting beam are respectively provided with a limiting structure to limit a position of the photovoltaic module in the corresponding supporting beam.

10. The mounting device of the claim 9, wherein the limiting structure comprises a limiting head and a fixing bolt, the limiting head is inserted into the sliding slot, and the fixing blot is fixed to the limiting head by passing through a slot bottom of the sliding slot.

11. The mounting device of any one of the claims 1 to 10, wherein the two supporting beams are respectively provided with a mounting structure, the mounting structure is movably connected to the corresponding supporting beam and configured to be connected to a mounting surface.

12. The mounting device of the claim 11, wherein the mounting structure is slidably disposed on the corresponding supporting beam.

13. The mounting device of the claim 12, wherein the two supporting beams are respectively provided with a mounting groove extending along a length direction of the corresponding supporting beam, a second sliding block is slidably disposed in the mounting groove;
the mounting structure has a connection portion connected to the second sliding block.

14. The mounting device of any one of the claims 11 to 13, wherein the mounting structure comprises a mounting fixture, a chuck is disposed on the mounting surface to cooperate with the mounting fixture.

15. A photovoltaic module assembly, comprising a photovoltaic module and the mounting device of any one of the claims 1 to 14
